# FASCICULE DE BREVET EUROPEEN

(11) **EP 2 981 156 B1**
(45) Date de publication et mention de la délivrance du brevet: **13.02.2019**
(21) Numéro de dépôt: 15178724.9
(22) Date de dépôt: 28.07.2015
(51) Int. Cl.: H05K 1/02, H05K 3/00, H05K 3/40, H01L 31/02, H01L 31/048, H01L 31/05, H01L 31/18

(54) **PANNEAU PHOTOVOLTAÏQUE ET UN PROCÉDÉ DE FABRICATION D'UN TEL PANNEAU**
FOTOVOLTAIKPANEEL UND EIN HERSTELLUNGSVERFAHREN EINES SOLCHEN PANEELS
PHOTOVOLTAIC PANEL AND METHOD FOR MANUFACTURING SUCH A PANEL

(30) Priorité: 29.07.2014 FR 1457322
(43) Date de publication de la demande: 03.02.2016
(73) Titulaire: BUBENDORFF, 68220 Attenschwiller (FR); Commissariat à l'Energie Atomique et aux Energies Alternatives, 75015 Paris (FR)
(72) Inventeur: GROSJEAN, Stéphane, 68640 Waldighoffen (FR); PILAT, Eric, 73100 BRISON SAINT INNOCENT (FR)
(74) Mandataire: Rhein, Alain

(56) Documents cités:
- WO-A2-2012/058053
- WO-A2-2013/182954
- US-A1- 2009 032 087
- ROSCA VICTOR ET AL: "Systematic reliability studies of back-contact photovoltaic modules", PROCEEDINGS OF SPIE, S P I E - INTERNATIONAL SOCIETY FOR OPTICAL ENGINEERING, US, vol. 8472, 16 octobre 2012 (2012-10-16), pages 84720D-84720D, XP060029245, ISSN: 0277-786X, DOI: 10.1117/12.930441

## Description

L'invention concerne un procédé de fabrication d'un panneau photovoltaïque, ainsi qu'un panneau photovoltaïque notamment issu de ce procédé.

La présente invention entre dans le domaine de la production d'énergie électrique par conversion du rayonnement solaire. Elle concerne plus particulièrement la fabrication de panneaux photovoltaïques encore appelés aussi capteurs ou modules solaires photovoltaïques. De tels panneaux ou capteurs sont des générateurs électriques de courant continu constitués d'un ensemble de cellules photovoltaïques reliées entre elles électriquement et insérées dans un compartiment étanche.

Ces panneaux servent de modules de base pour les installations photovoltaïques raccordées ou non à un réseau électrique notamment public de distribution. Ils peuvent délivrer de l'électricité en continu ou la stocker sur un accumulateur ou un condensateur.

Les cellules photovoltaïques sont constituées de semi-conducteurs, principalement à base de silicium et plus rarement d'autres semi-conducteurs : séléniure de cuivre et séléniure d'indium, tellurure de cadmium, etc. Le silicium utilisé pour les cellules est produit sous forme de barres. Ces barres sont ensuite sciées en fines plaques, en général, de 200 micromètres d'épaisseur et sont appelées usuellement dans le domaine technique considéré, « wafers ». D'ailleurs, dans la suite de la description, pour en faciliter la compréhension, ce terme sera systématiquement utilisé pour désigner ces fines plaques à base de silicium.

Après un traitement pour enrichir en éléments dopants (P, As, Sb ou B), on obtient ainsi du silicium semi-conducteur de type P ou N. Les wafers sont ensuite « métallisés ». Des rubans de métal sont incrustés sur l'une au moins des surfaces de ces wafers et reliés à des contacts électriques. Une fois métallisés les wafers sont devenus des cellules photovoltaïques. On distingue les différentes cellules en fonction de la qualité du silicium, c'est à dire monocristallin, polycristallin, amorphe ou de la technologie utilisée, c'est à dire en tandem, organiques, polymères, multifonction ou encore CIGS.

Les dimensions des cellules les plus répandues pour ce type de panneaux sont standardisées, car fabriquées à très grande échelle, en général 156 x 156 mm.

Ces cellules, de façon générale, sont très fragiles et doivent être protégées de dommages mécaniques et de l'humidité.

L'étape suivante dans la production est l'assemblage des cellules par des connections électriques en parallèle ou en série selon l'intensité ou le voltage désiré. Le tout est disposé sur une plaque et installé dans un cadre étanche.

Il peut être nécessaire d'emprisonner les cellules dans un polymère liquide gélatineux pour assurer leur immobilisation à l'intérieur du panneau ainsi réalisé.

On connait plus particulièrement par le document US2009/0032087, un procédé de fabrication de panneau photovoltaïque à concentration utilisant des cellules photovoltaïques ne comportant que des contacts électriques sur leur face arrière. Ce procédé consiste à utiliser une plaque support flexible comportant un circuit imprimé recouvert d'une couche de verni, tout en laissant apparaitre des zones de contact électriques destinées à coopérer avec les contacts électriques des cellules. Sous cette dernière, entre ces zones de contacts électriques, sont insérées des feuilles d'un matériau de comblement qui, par un procédé thermique ou sous UV est fondu pour diffuser entre les cellules et la plaque support de manière à assurer leur immobilisation et protection.

Dans ce document il est prévu d'utiliser les cellules dans leurs dimensions standards, reposant au travers d'une pluralité de zones de contacts sur le circuit imprimé de la plaque support flexible assurant leur stabilité et leur tenue mécanique au cours des opérations suivantes de cuisson et/ou de laminage. Les feuilles de matériau de comblement disposées sous ces cellules n'assurent, ici, aucune fonction mécanique de positionnement et une telle fonction n'est nullement prévue dans ce document antérieur. Elles ont pour seule fonction de garantir un parfait remplissage des interstices entre les cellules et leur support, lors de l'opération de fusion.

Si, comme indiqué plus haut, les cellules photovoltaïque sont fabriquée en grande série dans des dimensions standard, il est, soit nécessaire de les adapter, soit en concevoir de nouvelles pour la fabrication de panneaux photovoltaïques répondant à des besoins particuliers.

Le principal inconvénient de la conception de cellules photovoltaïques sur mesure est le coût important d'une telle production.

La seconde solution consiste en la découpe des cellules standards à dimensions voulues, par exemple à l'aide de la technologie identifiée sous la marque déposée Laser Micro Jet® développée par la société Synova. Il s'agit d'une découpe en escalier qui permet de limiter encore d'avantage le risque de shunt entre les circuits métallisés sur et sous la cellule. En outre, les technologies de découpe laser permettent des découpes partielles du wafer selon le contour de la mini cellule recherchée. Contrairement, le sciage impose une découpe totale, d'un coté à l'autre du wafer.

Quoiqu'il en soit, de telles cellules de petite dimension voire recoupées, s'avèrent encore plus fragile à manipuler et n'offrent nécessairement qu'un nombre réduit de contacts électriques pour leur raccordement sur le circuit électrique.

La problématique réside dans la conception de panneaux par un procédé dit CMS, pour Composant Monté en Surface, notamment à partir de cellules recoupées. Ce procédé industriel, bien plus économique à une solution manuelle, peut avoir pour conséquence de soumettre les composants à des contraintes que ne peuvent supporter les cellules, en particulier si elles sont recoupées ou de petites dimensions limitant leurs zones de contact et donc d'appui sur le circuit imprimé.

Ainsi, la présente invention a pour but de pallier les inconvénients de l'état de la technique, en proposant un procédé de fabrication de panneaux photovoltaïques qui consiste en des étapes suivantes :
- On dépose un motif métallique sur une carte de circuit imprimé ;
- On applique au moins une couche de vernis épargne sur la ladite carte en laissant au moins une zone de raccordement libre de vernis ;
- On applique sur tout ou partie de cette dite couche de vernis épargne un premier masque constitué d'un film polymère pour former un appui à au moins une cellule photovoltaïque;
- On applique sur tout ou partie de ce dit premier masque un second masque également constitué d'un film polymère délimitant au moins tout ou partie un cadre d'implantation d'une cellule photovoltaïque ;
- On dépose au moins une cellule photovoltaïque dans ledit cadre d'implantation en faisant concorder au moins une zone de raccordement définie sous ladite cellule photovoltaïque avec au moins une zone de raccordement sur ledit circuit métallique ;
- On effectue une opération de liage.

Les avantages découlant de la présente invention consistent en ce que le procédé de fabrication est susceptible d'être mis en oeuvre sur une ligne de fabrication automatisée sans intervention manuelle. Il en résulte un coût de fabrication moindre et une fiabilité de résultat améliorée. De plus, ce procédé selon l'invention permet d'obtenir un panneau photovoltaïque dont les cellules sont parfaitement positionnées et immobilisées évitant tout risque de mise sous contrainte de ces cellules, ceci sans qu'il soit utile d'utiliser un polymère de comblement de mise oeuvre délicate.

Avantageusement, ledit vernis épargne laisse libre un espace particulier le long dudit motif métallique.

Préférentiellement, ledit vernis épargne recouvre une zone transversale dudit motif métallique.

Selon un mode de réalisation avantageux, ladite couche de vernis épargne est d'épaisseur sensiblement égale à l'épaisseur du motif métallique.

Selon une autre particularité de l'invention le premier masque est d'épaisseur correspondant sensiblement à celle du matériau de liage.

Selon un mode de réalisation avantageux, le second masque comporte une épaisseur au moins égale, préférentiellement supérieure, à l'épaisseur d'une cellule photovoltaïque.

Selon un mode de réalisation, après dépose d'au moins une cellule photovoltaïque dans ledit cadre d'implantation on dépose au moins une languette de jonction s'étendant entre une zone de raccordement sur ledit motif métallique et une zone de raccordement sur ladite cellule photovoltaïque.

Selon encore un autre mode de réalisation, ladite opération de liage est un brasage.

Préférentiellement, ladite cellule est déposée à la fois sur une crème à braser et sur ledit premier masque.

Selon encore un autre mode de réalisation, ledit premier masque est constitué de polyamide.

D'autres caractéristiques et avantages de l'invention ressortiront de la description détaillée qui va suivre des modes de réalisation non limitatifs de l'invention, en référence aux figures annexées, dans lesquelles :
- la figure 1 représente schématiquement une vue de dessus d'un panneau solaire ou face exposée aux rayonnements lumineux, issu du procédé selon l'invention ;
- la figure 2 représente schématiquement en perspective et éclatement d'un panneau photovoltaïque selon un premier mode de réalisation ;
- la figure 3 est une vue similaire à la figure 2, mais correspondant à un second mode de réalisation ;
- la figure 4 est une représentation en coupe longitudinale d'un panneau photovoltaïque selon le premier mode de réalisation de la figure 2 ;
- la figure 5 représente schématiquement une vue latérale en coupe et longitudinale de l'assemblage d'un panneau photovoltaïque selon un autre mode de réalisation ;
- la figure 6 représente schématiquement une vue de dessus d'un détail de l'assemblage d'un panneau photovoltaïque ;
- la figure 7 est une vue en coupe longitudinale du même détail de l'assemblage d'un panneau photovoltaïque que la figure 6 ;
- la figure 8 représente schématiquement une vue de dessus de l'assemblage d'un panneau photovoltaïque ;
- la figure 9 représente schématiquement une vue en coupe transversale d'un panneau photovoltaïque en cours de fabrication avant l'opération de liage ;
- la figure 10 est une vue similaire à la figure 9 après liage.

Tel que représenté dans les différentes figures des dessins ci-joints, la présente invention concerne un panneau photovoltaïque encore appelé capteur ou module solaire photovoltaïque.

Tout particulièrement, l'invention concerne un procédé de fabrication d'un tel panneau photovoltaïque 1.

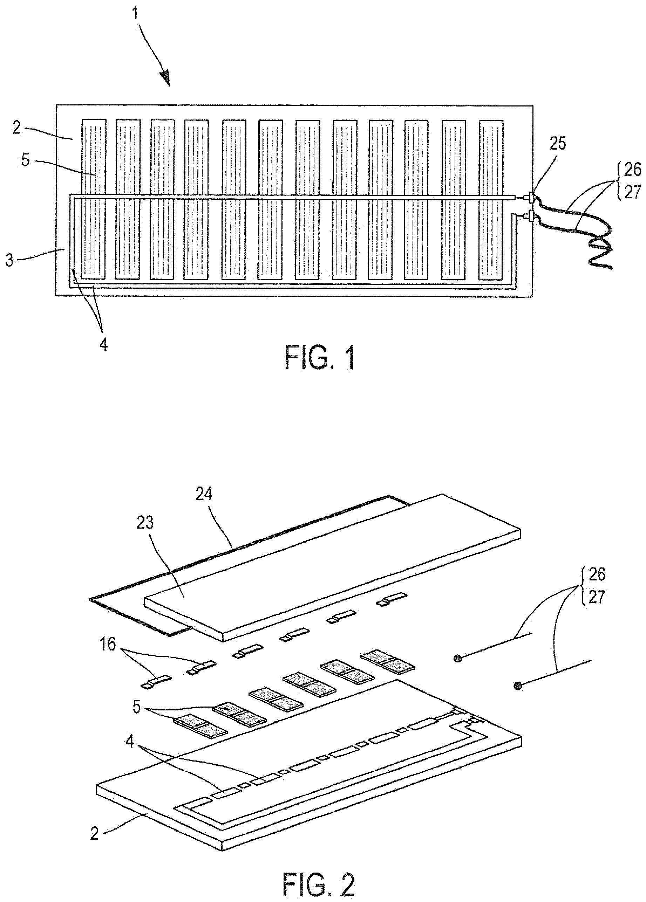

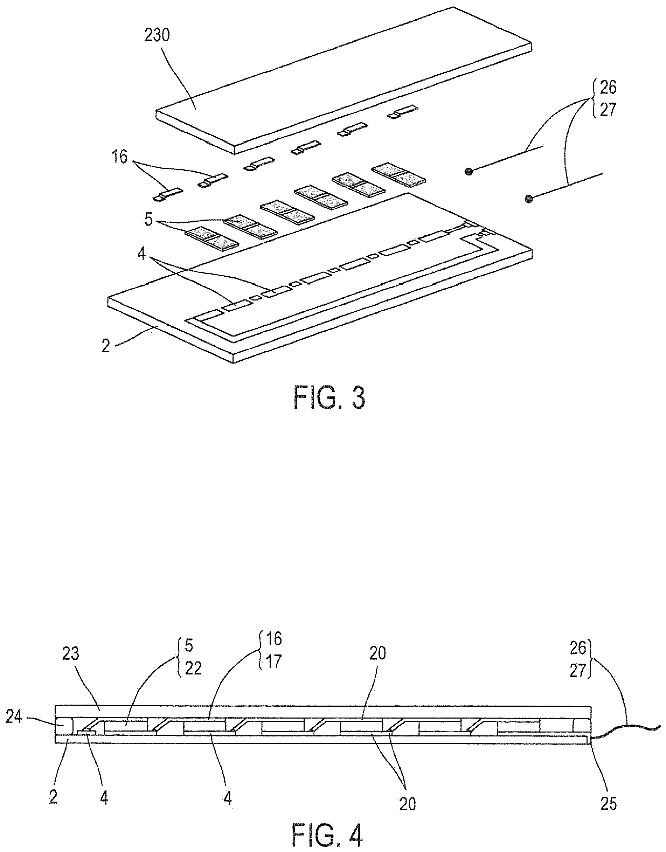

Ainsi, et tel que l'illustrent les figures 1 à 5, ce panneau photovoltaïque 1 comporte une carte de circuit imprimée 2 sur la face supérieure 3 de laquelle est réalisé au moins un motif métallique 4 destiné à contribuer au raccordement électrique d'une ou plusieurs cellules photovoltaïques 5.

Le motif métallique 4 peut être constitué de cuivre, d'alliage comportant du cuivre ou de tout autre métal ou alliage de métaux.

Préférentiellement, les cellules 5 sont des cellules photovoltaïques de type polycristallin découpées par Laser Micro Jet®. Ce découpage permet d'obtenir des petites cellules avec un taux de shunt faible.

Bien entendu, la présente invention n'est nullement limitée à un tel procédé de découpe. D'autres techniques, telles que le sciage ou la découpe par laser thermique peuvent aussi être utilisées.

Il est a noté aussi que l'invention permet d'utiliser des types de cellules ayant une qualité de silicium différente ou de technologie différente. Ces cellules 5 peuvent être montées en parallèle et/ou en série selon l'intensité ou le voltage désiré. Il est aussi possible d'établir une connexion entre chaque cellule pour avoir accès à autant de niveau de tension et obtenir plusieurs branchements de sortie.

Cette carte de circuit imprimé 2 peut être une carte généralement utilisée dans le domaine de l'électronique comme support d'un circuit. Toutefois et de manière préférentielle, cette carte de circuit imprimée 2 est en un matériau étanche à l'eau.

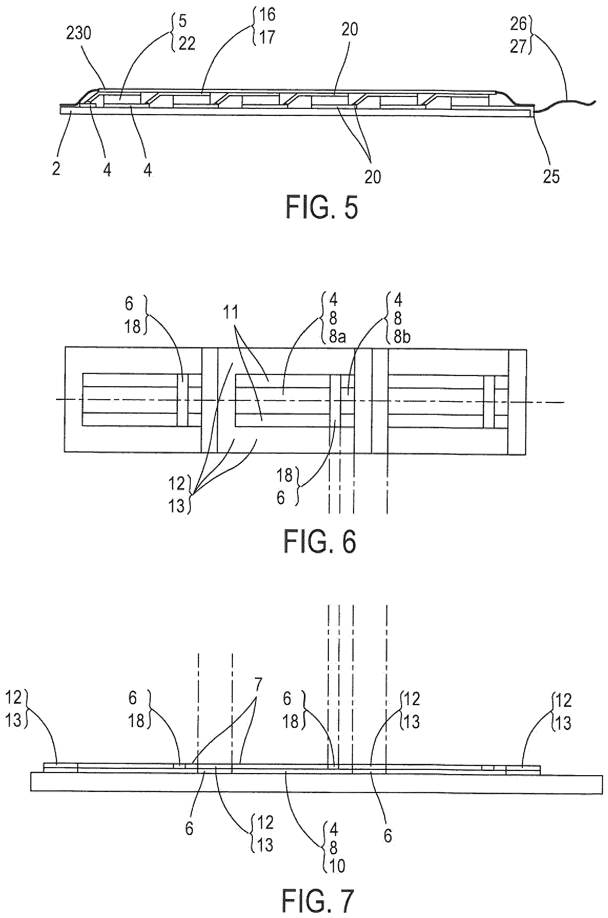

Selon l'invention, et comme visible sur les figures 6, 7, 9 et 10, on vient appliquer sur cette face 3 de la carte de circuit imprimée 2, au moins une couche de vernis épargne 6 en laissant au moins une zone libre de vernis 7. Une telle zone 7 est, par exemple, susceptible de constituer une zone de raccordement 8 d'une cellule photovoltaïque 5 sur cette carte de circuit imprimé 2 comme cela sera décrit plus en avant.

De manière avantageuse, cette couche de vernis épargne 6 est d'épaisseur 9 sensiblement égale à l'épaisseur 10 du motif métallique 4.

A noter encore, que de part et d'autre des zones de raccordement 8 sur le motif métallique 4, des espaces 11 sont avantageusement préservés par le vernis épargne 6 dont l'usage apparaîtra plus en avant dans la description.

Selon l'invention encore, on vient appliquer sur toute ou partie de cette couche de vernis épargne 6, un premier masque 12 constitué avantageusement, d'un film polymère sur lequel est destiné à reposer, au moins en partie, une cellule photovoltaïque 5. Ce premier masque vient par conséquent former un appui à une telle cellule.

A ce propos, sur ce premier masque 12 est disposé un second masque 14 également sous forme d'un film polymère délimitant au moins toute ou partie d'un cadre d'implantation 15 pour une telle cellule photovoltaïque 5.

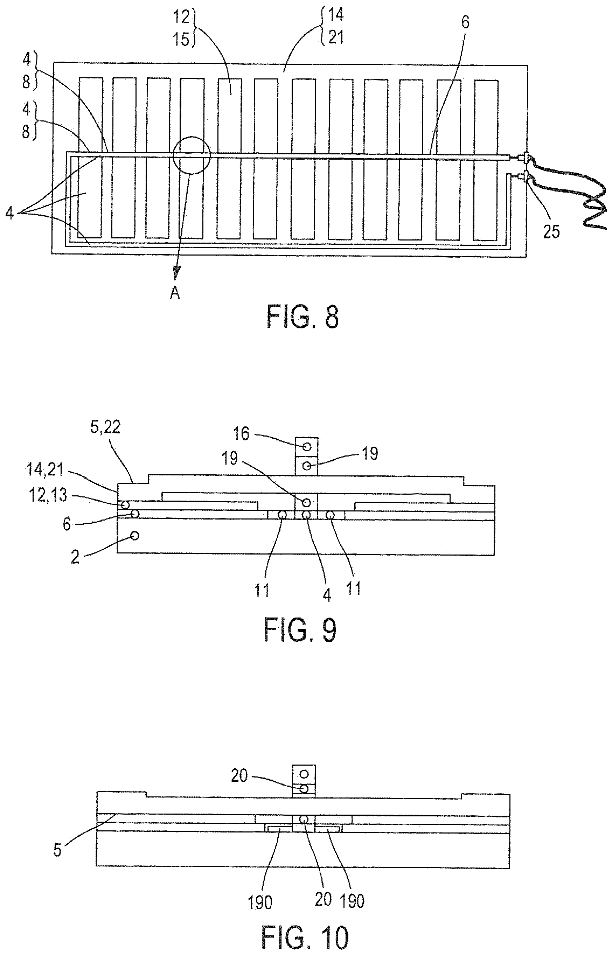

Très substantiellement et tel que visible dans la figure 8, ce second masque 14 définit une pluralité de cadres d'implantation 15, chacun étant apte à recevoir une cellule photovoltaïque 5 aux dimensions appropriées. Au travers de ce second masque 14, ces cellules photovoltaïques 5 sont parfaitement positionnées au-dessus de la carte de circuit imprimé 2, en particulier, au-dessus des zones de raccordement 8 par l'intermédiaire desquelles lesdites cellules photovoltaïques 5 doivent être raccordées électriquement sur cette carte de circuit imprimé 2, plus particulièrement, sur le motif métallique 4.

Les cadres d'implantation 15 s'apparentent à des berceaux d'accueil pour les cellules et évitent qu'elles ne se déplacent, notamment pendant l'opération de brasage qui peut se faire sous flux d'air chaud.

En conjonction, avec le 1er masque formant surface d'appui au moins partiel en périphérie, il est évité le phénomène dit «d'ailes de papillon» lorsque les cellules 5 sont fixées sur la carte de circuit 2. La position verticale des cellules 5 est ainsi finement ajustée, ces dernières reposent bien à plat.

A noter que les cellules photovoltaïque 5 peuvent être à raccordement monoface, c'est-à-dire qu'elles comportent exclusivement des zones de raccordement sur leur face arrière destinées à coopérer avec des zones de raccordement 8 la carte de circuit imprimé 2 ou biface. Dans ce dernier cas de figure, plus particulièrement représenté dans les dessins ci-joints, ces cellules comportent, sur chacune de leurs faces de telles zones destinées à être raccordées audit circuit imprimé. Corne visible sur les figures, lesdites zones de raccordement 8 se décomposent, alors, en des premières zones de raccordement 8a au niveau desquelles est réalisé plus particulièrement cette connexion des cellules photovoltaïques 5 sur la carte de circuit imprimé 2 et des secondes zones de raccordement 8b pour le raccordement entre des languettes de jonction 16 s'étendant entre le motif métallique 4 et une zone de raccordement 17 sur une cellule photovoltaïque 5.

En conséquence, une étape du procédé selon l'invention, lorsqu'il est mis en oeuvre des cellules bifaces consiste à déposer une telle languette de jonction 17 entre une zone de raccordement 8b sur le motif métallique 4 et une zone de raccordement 17 sur une cellule photovoltaïque 5.

De manière préférentielle, sur le motif métallique 4, une barrière d'écoulement de flux 18 délimite les différentes zones de raccordement 8a, 8b, sur le motif métallique 4.

De manière avantageuse, ces barrières d'écoulement de flux 18 ou zones transversales sont réalisées lors de l'application de la couche de vernis épargne 6. L'usage de ces barrières 18 apparaîtra plus en avant dans la description.

A noter encore que, selon l'invention, sur les zones de raccordement 8a, 8b et celles 17 sur une cellule photovoltaïque 5, est déposé un matériau de liage 19 par exemple constitué de pâte à braser ou équivalent.

En particulier, sur les zones de raccordement 8a, ce matériau de liage 19 est appliqué avant que ne soit déposées les cellules photovoltaïques dans leur cadre d'implantation respectif 15. De même, sur les zones de raccordement 8b et 17, ce matériau de liage 19 ou composé liant est déposé avant la mise en place d'une languette de jonction 16.

De manière avantageuse, des points de colles peuvent être adjoints à ce matériau de liage 19 afin de garantir le maintien en position de la cellule lors du passage du panneau dans le four de refusions. Tout particulièrement, le flux d'air chaud peut provoquer des mouvements perturbateurs et empêcher les cellules (ou mini cellules) de se positionner adéquatement dans leur berceau ou cadre d'implantation respectif.

Par ailleurs, de manière préférentielle, cette dépose de ce matériau de liage 19 s'effectue sous forme de points de pâte à braser dont la taille, la forme et la surface, sont définies pour assurer une sustentation sensiblement isostatique des cellules 5 conditionnant l'appui parallèle de ces cellules sur le premier masque 12 lors de la refusions, limitant ainsi toute casse rédhibitoire.

Dans une opération suivante du procédé selon l'invention, on réalise le liage proprement dit, encore dénommée refusions, qui a pour conséquence la venue en applique des cellules photovoltaïques 5 sur le premier masque 12.

Comme cela apparaît dans la figure 10, le premier masque 12 est d'épaisseur 13 correspondant sensiblement à celle 20 du matériau de liage 19.

Cette étape de liage du procédé de l'invention est préférentiellement effectuée par un brasage et le matériau de liage 19 est une pâte à braser. Une soudure (en mode conventionnel) selon un procédé connu de l'homme du métier, un collage à l'aide d'un matériau électriquement conducteur, une fixation d'un autre ordre permettant une connexion électrique ou plus simplement une mise en contact sont aussi possible dans le cadre du procédé de l'invention.

Cette pâte de brasage est généralement composée en volume de 50% de flux 190 et 50% d'alliage métallique de brasage. Le flux 190 est un liquide fluidifiant et décapant dont une partie s'évapore pendant le brasage et une autre partie se sépare de l'alliage métallique. L'alliage métallique est généralement composé entre autres de cuivre et/ou d'argent et/ou d'autres métaux ou alliage de métaux.

Enfin, le processus de brasage est effectué par transfert thermique et/ou pression mécanique. Le transfert thermique peut être effectué sous un mode de conduction, de convection, de rayonnement ou une combinaison de ces modes de transfert.

Au cours de ce processus, une partie du flux 190 se dépose dans les espaces ou zones longitudinales 11 et un lien métallique est ainsi crée entre la cellule 5, le motif 4 et la languette de jonction 16.

Quand un brasage est effectué, le lien métallique se rétracte lors de son refroidissement et vient plaquer la cellule 5 dans son berceau résultant ainsi en une fiabilité accrue dans le temps.

Comme visible également sur la figure 10, le second masque 14 comporte, lui, une épaisseur 21 au moins égale, préférentiellement supérieure, à l'épaisseur 22 d'une cellule photovoltaïque 5.

A la suite de cette opération de liage, il est appliqué sur le panneau photovoltaïque 1 une plaque ou un film de recouvrement 23 en matériau translucide, préférentiellement transparent. Ainsi, cette plaque 23 peut être réalisée en un matériau minéral comme du verre ou tout autre matériau synthétique transparent ou translucide.

Dans le cas d'un film de recouvrement 230, celui-ci peut être constituée d'éthylène vinyle acétate, EVA, ou tout autre polymère ou copolymère ayant des propriétés de transparence aux rayons lumineux. De même, toute autre matière transparente au rayonnement lumineux peut être envisagée, comme par exemple le quartz, dans le but par exemple d'obtenir un dispositif sensible aux rayonnements ultra-violets, le corindon, etc...

Des moyens d'étanchéité périphériques 24 viennent parfaire ce panneau photovoltaïque 1. Dans le cas d'une plaque de recouvrement 23, de tels moyens d'étanchéité périphériques 24 peuvent être constitués d'un joint en matériau adapté par exemple, d'un joint butyle.

Dans le cadre d'un film de recouvrement, celui-ci peut, par soudure périphérique, constituer ces moyens d'étanchéité 24.

Selon encore une autre particularité de l'invention, sur au moins un des chants d'extrémité 25 de la carte de circuit imprimé 2, sont définis des bornes de raccordement 26, 27 en liaison électrique avec le motif électrique 4 et permettant le raccordement électrique du panneau photovoltaïque 1 ainsi constitué.

De manière avantageuse, la carte de circuit imprimé 2 peut accueillir tout ou partie de l'électronique nécessaire au bon fonctionnement du panneau photovoltaïque 1. A ce propos, dans la mesure où le procédé de réalisation d'un panneau photovoltaïque selon l'invention est assimilable à un procédé CMS, ces composants peuvent être disposés sur ladite carte de circuit imprimé 4 dans le cadre d'une étape complémentaire avant celle consistant au liage.

## Revendications

1. Procédé de fabrication de panneaux photovoltaïques (1) **caractérisé en ce que** ce procédé consiste en des étapes suivantes :
- On dépose un motif métallique (4) sur une carte de circuit imprimé (2) ;
- On applique au moins une couche de vernis épargne (6) sur la ladite carte (2) en laissant au moins une zone libre de vernis (7, 11) ;
- On applique sur tout ou partie de cette dite couche de vernis épargne (6) un premier masque (12) constitué d'un film polymère pour former un appui à au moins une cellule photovoltaïque (5);
- On applique sur tout ou partie de ce dit premier masque (12) un second masque (14) également constitué d'un film polymère délimitant au moins tout ou partie un cadre d'implantation (15) d'une cellule photovoltaïque (5) ;
- On dépose au moins une cellule photovoltaïque (5) dans ledit cadre d'implantation (15) en faisant concorder au moins une zone de raccordement (8, 8a) définie sous ladite cellule photovoltaïque (5) avec au moins une zone de raccordement (8, 8a) sur ledit circuit métallique (4) ;
- On effectue une opération de liage.

2. Procédé selon la revendication principale dans lequel ladite couche de vernis épargne (6) laisse libre un espace (11) le long du motif métallique (4).

3. Procédé selon l'une quelconque des revendications précédentes dans lequel ladite couche de vernis épargne (6) recouvre une zone transversale (18) dudit motif métallique (4).

4. Procédé selon l'une quelconque des revendications précédentes dans lequel ladite couche de vernis épargne (6) est d'épaisseur (9) sensiblement égale à l'épaisseur (10) du motif métallique (4).

5. Procédé selon l'une quelconque des revendications précédentes dans lequel le premier masque (12) est d'épaisseur (13) sensiblement égale à celle (20) du matériau de liage (19).

6. Procédé selon l'une quelconque des revendications précédentes dans lequel le second masque (14) comporte une épaisseur (21) au moins égale, préférentiellement supérieure, à l'épaisseur (22) d'une cellule photovoltaïque (5).

7. Procédé selon l'une quelconque des revendications précédentes dans lequel après dépose d'au moins une cellule photovoltaïque (5) dans ledit cadre d'implantation (15) on dépose au moins une languette de jonction (16) s'étendant entre une zone de raccordement (8, 8b) sur ledit motif métallique (4) et une zone de raccordement (17) sur ladite cellule photovoltaïque (5).

8. Procédé selon l'une quelconque des revendications précédentes dans lequel ladite opération de liage est un brasage.

9. Procédé selon la revendication 8 dans lequel ladite cellule (5) est déposée à la fois sur une crème à braser et sur ledit premier masque (12).

10. Procédé selon l'une quelconque des revendications précédentes dans lequel ledit premier masque (12) est constitué d'un film polyamide.

## Patentansprüche

1. Verfahren zur Herstellung von Photovoltaikpaneelen (1), **dadurch gekennzeichnet, dass** dieses Verfahren aus den folgenden Schritten besteht:
- Aufbringen eines metallischen Motivs (4) auf eine Leiterplatte (2);
- Auftragen mindestens einer Schicht Decklack (6) auf die Platte (2) bei Freilassen mindestens einer Zone von Lack (7, 11);
- Auftragen auf die gesamte oder einen Teil dieser Schicht Decklack (6) einer ersten Maske (12), gebildet von einem Polymerfilm, um eine Abstützung für mindestens eine Photovoltaikzelle (5) zu bilden;
- Auftragen auf die gesamte oder einen Teil dieser ersten Maske (12) einer zweiten Maske (14), die ebenfalls von einem Polymerfilm gebildet ist, die mindestens ganz oder teilweise einen Platzierungsrahmen (15) einer Photovoltaikzelle (5) begrenzt;
- Aufbringen mindestens einer Photovoltaikzelle (5) in den Platzierungsrahmen (15) durch Abstimmen mindestens einer unter der Photovoltaikzelle (5) definierten Anschlusszone (8, 8a) mit mindestens einer Anschlusszone (8, 8a) auf dem metallischen Kreis (4);
- Durchführen eines Verbindungsvorgangs.

2. Verfahren nach dem Hauptanspruch, wobei die Schicht Decklack (6) einen Platz (11) entlang des metallischen Motivs (4) freilässt.

3. Verfahren nach einem der vorangehenden Ansprüche, wobei die Schicht Decklack (6) eine transversale Zone (18) des metallischen Motivs (4) bedeckt.

4. Verfahren nach einem der vorangehenden Ansprüche, wobei die Schicht Decklack (6) etwa derselben Stärke (9) wie die Stärke (10) des metallischen Motivs (4) ist.

5. Verfahren nach einem der vorangehenden Ansprüche, wobei die erste Maske (12) etwa derselben Stärke (13) wie die (20) des Verbindungsmaterials (19) ist.

6. Verfahren nach einem der vorangehenden Ansprüche, wobei die zweite Maske (14) eine Stärke (21) aufweist, die mindestens gleich, vorzugsweise größer, als die Stärke (22) einer Photovoltaikzelle (5) ist.

7. Verfahren nach einem der vorangehenden Ansprüche, wobei nach dem Aufbringen von mindestens einer Photovoltaikzelle (5) in den Platzierungsrahmen (15) mindestens eine Verbindungszunge (16) aufgebracht wird, die sich zwischen einer Anschlusszone (8, 8b) auf dem metallischen Motiv (4) und einer Anschlusszone (17) auf der Photovoltaikzelle (5) erstreckt.

8. Verfahren nach einem der vorangehenden Ansprüche, wobei der Verbindungsvorgang ein Löten ist.

9. Verfahren nach Anspruch 8, wobei die Zelle (5) gleichzeitig auf eine Lötpaste und auf die erste Maske (12) aufgebracht wird.

10. Verfahren nach einem der vorangehenden Ansprüche, wobei die erste Maske (12) von einem Polyamidfilm gebildet ist.

## Claims

1. A method for manufacturing photovoltaic panels (1), **characterized in that** the method consists of the following steps:
- Depositing a metal pattern (4) on a printed circuit board (2) ;
- Applying at least one layer of resist (6) on said board (2), leaving at least one zone free of resist (7, 11);
- Applying, on all or part of said layer of resist (6), a first mask (12) made up of a polymer film to form support for at least one photovoltaic cell (5);
- Applying, on all or part of said first mask (12), a second mask (14) also made up of a polymer film delimiting at least all or part of an installation frame (15) for a photovoltaic cell (5);
- Depositing at least one photovoltaic cell (5) in said installation frame (15) by matching at least one connecting zone (8, 8a) defined below said photovoltaic cell (5) with at least one connecting zone (8, 8a) on said metal circuit (4);
- Performing a bonding operation.

2. The method according to the primary claim, wherein said resist layer (6) leaves a free space (11) along the metal pattern (4) .

3. The method according to any one of the preceding claims, wherein said resist layer (6) covers a transverse zone (18) of said metal pattern (4).

4. The method according to any one of the preceding claims, wherein said resist layer (6) has a thickness (9) substantially equal to the thickness (10) of the metal pattern (4).

5. The method according to any one of the preceding claims, wherein said resist layer (12) has a thickness (13) substantially equal to that (20) of the bonding material (19).

6. The method according to any one of the preceding claims, wherein the second mask (14) includes a thickness (21) at least equal to, preferably greater than, the thickness (22) of a photovoltaic cell (5).

7. The method according to any one of the preceding claims, wherein after depositing at least one photovoltaic cell (5) in said installation frame (15), at least one junction tongue (16) is deposited extending between a connecting zone (8, 8b) over said metal pattern (4) and a connecting zone (17) over said photovoltaic cell (5).

8. The method according to any one of the preceding claims, wherein said bonding operation is a brazing.

9. The method according to claim 8, wherein said cell (5) is deposited both on a brazing paste and on said first mask (12).

10. The method according to any one of the preceding claims, wherein said first mask (12) is made from a polyamide film.
